Europäisches Patentamt

European Patent Office

Office européen des brevets

(19)

(11) EP 0 874 879 B1

(12) FASCICULE DE BREVET EUROPEEN

(45) Date de publication et mention
de la délivrance du brevet:
**24.11.2004 Bulletin 2004/48**

(21) Numéro de dépôt: **97900649.1**

(22) Date de dépôt: **17.01.1997**

(51) Int Cl.[7]: **C09K 11/78**

(86) Numéro de dépôt international:
**PCT/FR1997/000069**

(87) Numéro de publication internationale:
**WO 1997/026312 (24.07.1997 Gazette 1997/32)**

(54) **BORATE DE TERRE RARE ET SON PRECURSEUR, LEURS PROCEDES DE PREPARATION ET L'UTILISATION DU BORATE COMME LUMINOPHORE**

MIT SELTENEN ERDEN AKTIVIERTES BORAT UND SEIN VORLÄUFER, IHR HERSTELLUNGSVERFAHREN UND DIE BORATVERWENDUNG ALS LEUCHTSTOFF

RARE EARTH BORATE AND ITS PRECURSOR, PREPARATION PROCESSES AND USE OF BORATE AS LUMINOPHORE

(84) Etats contractants désignés:
**AT DE FR GB IT NL**

(30) Priorité: **17.01.1996 FR 9600467**

(43) Date de publication de la demande:
**04.11.1998 Bulletin 1998/45**

(73) Titulaire: **RHODIA CHIMIE
92408 Courbevoie Cédex (FR)**

(72) Inventeurs:
• **HUGUENIN, Denis
F-92600 Asnières-sur-Seine (FR)**

• **MACAUDIERE, Pierre
F-92600 Asnières-sur-Seine (FR)**

(74) Mandataire: **Boittiaux, Vincent
Rhodia Services,
DPI,
40, rue de la Haie-Coq
93306 Aubervilliers Cedex (FR)**

(56) Documents cités:
**FR-A- 2 358 457          GB-A- 1 022 399
US-A- 4 246 246**

EP 0 874 879 B1

**Description**

La présente invention concerne un borate de terre rare, un précurseur de celui-ci, leurs procédés de préparation et l'utilisation de ce borate comme luminophore.

Les domaines de la luminescence et de l'électronique connaissent actuellement des développements importants. On peut citer comme exemple de ces développements, ta mise au point des systèmes à plasma (écrans et lampes) pour les nouvelles techniques de visualisation et d'éclairage. Une application concrète est celle du remplacement des écrans de télévision actuels par des écrans plats. Ces nouvelles applications nécessitent des matériaux luminophores présentant des propriétés de plus en plus améliorées. Ainsi, outre leur propriété de luminescence, on demande à ces matériaux des caractéristiques spécifiques de morphologie ou de granulométrie afin de faciliter notamment leur mise en oeuvre dans les applications recherchées.

Plus précisément, il est demandé d'avoir des luminophores ayant une répartition granulométrique resserrée et, éventuellement, sous forme de particules individualisées de taille micronique.

L'objet principal de l'invention est de procurer des produits ayant de telles caractéristiques granulométriques.

Un autre objet de l'invention est de procurer des luminophores à propriétés de luminescence améliorées.

Un troisième objet de l'invention est un procédé de préparation permettant d'obtenir directement des produits présentant ces caractéristiques.

Dans ce "but, le borate de terre rare de l'invention est caractérisé par la formule $LnBO_3$, Ln représentant au moins une terre rare et en ce qu'il se présente sous forme de particules cubiques, parallélépipédiques ou sphériques et en ce qu'il présente un indice de dispersion d'au plus 0,8.

L'invention concerne aussi, à titre de précurseur d'un borate, un hydroxycarbonate de bore et de terre rare, caractérisé en ce qu'il se présente sous forme de particules cubiques, parallélépipédiques ou sphériques et en ce qu'il présente un indice de dispersion d'au plus 0,8.

Comme autre produit, l'invention concerne par ailleurs, à titre de précurseur d'un borate, un hydroxycarbonate de bore et d'yttrium, comprenant en outre du terbium, à propriétés de luminescence.

L'invention couvre aussi un procédé de préparation d'un hydroxycarbonate de bore et de terre rare de formule $Ln\ B(OH)_4CO_3$, Ln représentant au moins une terre rare, caractérisé en ce qu'on fait réagir un carbonate ou un hydroxycarbonate de terre rare avec de l'acide borique, le milieu réactionnel se présentant sous forme d'une solution aqueuse.

L'invention couvre, en outre, un procédé de préparation d'un borate de terre rare, caractérisé en ce qu'on fait réagir un carbonate ou un hydroxycarbonate de terre rare avec de l'acide borique, la milieu réactionnel se présentant sous forme d'une solution aqueuse, et on calcine le produit de la réaction.

D'autres caractéristiques, détails et avantages de l'invention apparaîtront encore plus complètement à la lecture de la description qui va suivre et des dessins annexés dans lesquels :

- la figure 1 est un graphe donnant l'intensité d'émission en fonction de la longueur d'onde pour un borate d'yttrium dopé à l'europium selon l'invention, sous une excitation à 254nm;
- la figure 2 est un graphe donnant l'intensité d'émission en fonction de la longueur d'onde sous la même excitation, pour un produit de même formule selon l'art antérieur, préparé par chamottage.

Par terre rare on entend, pour l'ensemble de la description, les éléments du groupe constitué par l'yttrium, le scandium et les éléments de la classification périodique de numéro atomique compris inclusivement entre 57 et 71.

Les procédés de préparation vont tout d'abord être décrits et les produits obtenus aux différentes étapes seront ensuite étudiés en détail.

Une caractéristique des procédés de l'invention est le produit de départ. On part d'un carbonate ou d'un hydroxycarbonate de terre rare.

On peut partir d'un mélange de carbonates ou d'hydroxycarbonates de terres rares différentes ou de carbonates ou d'hydroxycarbonates mixtes de terres rares. En effet, l'invention s'applique aux borates d'une ou de plusieurs terres rares ou aux hydroxycarbonates de bore et d'une ou de plusieurs terres rares. C'est pourquoi, dans l'ensemble de la description, tout ce qui est décrit au sujet d'un borate de terre rare, d'un hydroxycarbonate de bore et de terre rare et au sujet de leurs procédés de préparation doit s'entendre comme s'appliquant au cas où plusieurs terres rares sont présentes.

Les carbonates ou hydroxycarbonates de terres rares sont des produits connus en soi et que l'on peut obtenir par exemple par précipitation d'un ou de plusieurs sels de terre rare avec du carbonate ou du bicarbonate d'ammonium.

On fait réagir le produit de départ avec de l'acide borique. De préférence, on conduit la réaction à chaud, par exemple à une température comprise entre 40°C et 90°C.

Selon une autre caractéristique de l'invention, le milieu réactionnel se présente sous forme d'une solution aqueuse. Cela signifie que la quantité d'eau présente dans le milieu réactionnel est telle que le rapport massique eau/acide borique+carbonate soit d'au moins 300%, plus particulierement d'au moins 1000%. Ce rapport peut être encore plus particulièrement d'au moins 1500%.

On peut travailler avec un excès d'acide borique. Cet excès peut être par exemple compris entre 5% et 100% en mole ([B]/[TR] = 1,05 à 2, TR=Terre Rare).

Il peut être avantageux de réaliser la réaction en éliminant le $CO_2$ formé au cours de celle-ci. Cet élimination peut se faire par exemple en balayant le milieu réactionnel avec un gaz neutre comme l'azote. Cette variante permet d'obtenir des produits de granulométrie plus fine.

Selon une autre variante, on effectue la réaction en attaquant par l'acide borique le carbonate ou l'hydroxycarbonate de terre rare dans les eaux-mères de précipitation de celui-ci. Il est avantageux de procéder à cette attaque sur un carbonate ou hydroxycarbonate fraîchement préparé. Cette variante permet d'obtenir des produits de morphologie sphérique.

A la fin de la réaction, on obtient un précipité qui est séparé du milieu réactionnel par tout moyen connu, par exemple par filtration et qui, éventuellement, est lavé puis séché. Un des avantages du procédé de l'invention est qu'il permet d'obtenir un précipité qui peut facilement être filtré et lavé. Après le séchage, on peut aussi effectuer un lavage supplémentaire avec un acide dilué, par exemple de l'acide nitrique pour éliminer les traces possibles de carbonate n'ayant pas totalement réagi.

On obtient ainsi l'hydroxycarbonate de bore et de terre rare de l'invention.

Le procédé de préparation des borates de l'invention est aussi caractérisé en ce qu'on fait réagir un carbonate ou un hydroxycarbonate de terre rare avec de l'acide borique. On récupère le précipité à l'issue de cette réaction et tout ce qui a été dit plus haut pour cette réaction et le traitement du précipité s'applique aussi ici pour cette première étape du procédé. Le précipité est ensuite calciné.

Cette calcination se fait généralement à une température comprise entre 500 et 1400°C, plus particulièrement entre 500 et 1100°C. Compte tenu des propriétés du précipité d'hydroxycarbonate, il est tout à fait possible de réaliser cette calcination sous air. Il s'agit là d'un avantage intéressant par rapport aux procédés de l'art antérieur qui nécessitent généralement des atmosphères réductrices. Bien entendu, on ne sortirait pas du cadre de la présente invention en mettant en oeuvre pour cette calcination des atmosphères réductrices (hydrogène par exemple) ou neutre (argon) ou des mélanges de celles-ci.

A l'issue de la calcination, on obtient un borate selon l'invention.

Un autre avantage important du procédé est qu'il permet d'obtenir directement un borate ayant les caractéristiques de granulométrie recherchées. Il n'est pas nécessaire par exemple d'effectuer un broyage pour se ramener à la taille de particules désirée.

Le borate de l'invention va maintenant être décrit.

Le borate de terre rare de l'invention est un orthoborate de formule $LnBO_3$, Ln représentant au moins une terre rare.

La première caractéristique de ce borate est sa morphologie.

Le borate de l'invention peut se présenter sous forme de particules sphériques, cubiques ou parallélépipèdiques. Le terme parallélépipédique couvre également les produits sous forme de plaquettes, c'est à dire en fait des parallélépipèdes dont la hauteur est faible ou très faible par rapport à la longueur.

Ces particules peuvent aussi présenter une taille qui varie dans de larges proportions. Selon un mode de réalisation préféré de l'invention, la taille moyenne de particules est d'au plus 10μm, plus particulièrement d'au plus 5μm et, encore plus particulièrement, elle peut être comprise entre 0,5 et 5μm.

Pour l'ensemble de la description, la taille moyenne et l'indice de dispersion sont les valeurs obtenues en mettant en oeuvre la technique de diffraction laser en utilisant un granulomètre du type CILAS HR 850 (répartition en volume).

Les particules ont une morphologie homogène, c'est à dire que la majorité d'entre elles et, de préférence la totalité, ont cette même morphologie.

Une autre caractéristique du borate de l'invention est sa répartition granulométrique. Cette répartition granulométrique est resserrée. Ainsi, l'indice de dispersion σ/m est d'au plus 0,8. Il peut être plus particulièrement d'au plus 0,7 et encore plus particulièrement d'au plus 0,6. Il est possible, dans le cadre de la présente invention, d'obtenir des produits présentant un indice de dispersion de 0,4 ou 0,5.

On entend par indice de dispersion le rapport :

$$\sigma/m = (d_{90}-d_{10})/2d_{50}$$

dans lequel:

- $d_{90}$ est le diamètre des particules pour lequel 90% des particules ont un diamètre inférieur à $d_{90}$;
- $d_{10}$ est le diamètre des particules pour lequel 10% des particules ont un diamètre inférieur à $d_{10}$:

- $d_{50}$ est le diamètre moyen des particules.

Les diamètres sont déterminés par granulométrie Cilas (répartition en masse).

Le borate de l'invention peut en outre se présenter sous forme de particules bien séparées et individualisées. Il n'y a pas ou peu d'agglomérats de particules. De ce fait, le borate peut se présenter sous la forme de particules de taille, d'indice de dispersion et de morphologie tels que décrits plus haut, ces particules étant substantiellement entières. Par particule entière, on entend une particule qui n'a pas été rompue ou brisée comme cela est le cas lors d'un broyage. Les photos en microscopie électronique à balayage permettent de distinguer des particules brisées de particules qui ne l'ont pas été.

La terre rare constitutive du borate de l'invention, c'est à dire celle qui forme avec le bore la matrice du produit appartient généralement au groupe des terres rares qui n'ont pas de propriété de luminescence. Ainsi, cette terre rare constitutive du borate peut être choisie, seule ou en combinaison, dans le groupe comprenant l'yttrium, le gadolinium, le lanthane, le lutécium et le scandium. Elle peut être plus particulièrement l'yttrium et/ou le gadolinium.

Le borate peut, en outre, comprendre un ou plusieurs dopants. D'une manière connue en soi, les dopants sont utilisés en combinaison avec la matrice pour lui donner des propriétés de luminescence. Ces dopants peuvent être choisis parmi l'antimoine, le bismuth et les terres rares. Dans ce dernier cas, la ou les terres rares utilisées comme dopant sont choisies dans le groupe des terres rares à propriétés de luminescence et elles sont différentes de la terre rare constitutive du borate. Comme terre rare dopante, on peut citer le cérium, le terbium, l'europium, le thulium, l'erbium et le praséodyme. On utilise plus particulièrement le terbium et l'europium. La teneur en dopant est habituellement d'au plus 50% en mole par rapport à la matrice borate de terre rare (rapport [dopant]/[$\sum$TRBO$_3$]), $\sum$TR représentant l'ensemble terres rares et dopants dans le borate. Dans le cas particulier de l'europium et du terbium, les teneurs en ces éléments sont préférentiellement comprises entre 5 et 25% et 5 et 50% respectivement. Dans le cas du thulium, la teneur en thulium est préférentiellement comprise entre 0,1 et 1%.

Selon un mode de réalisation particulier, le borate de terre rare de l'invention est un borate d'au moins un élément choisi parmi l'yttrium, le gadolinium, le scandium et le lutécium. Il est caractérisé en ce qu'il comprend, à titre de dopant, de l'europium et en ce qu'il présente un maximum d'intensité d'émission dans la gamme de longueur d'onde ($\lambda$) comprise entre 600 et 650nm sous une excitation à 254nm. On entend par maximum d'intensité d'émission le fait que la valeur de l'intégrale de la courbe : intensité = f($\lambda$) pour les valeurs de $\lambda$ de 600 à 650nm représente la partie majoritaire de la valeur de l'intégrale de la même courbe pour les valeurs de $\lambda$ variant dans tout le domaine du visible. De ce fait, le borate selon ce mode de réalisation est un luminophore rouge, émettant essentiellement dans cette couleur, contrairement aux luminophores de même composition de l'art antérieur qui émettent essentiellement dans l'orange, c'est à dire dans des longueurs d'onde inférieures à 600nm.

La teneur en europium dans le borate de ce mode de réalisation est généralement d'au plus 50% calculé comme décrit plus haut.

Enfin, dans ce mode de réalisation, l'élément terre rare est plus particulièrement l'yttrium et/ou le gadolinium.

Comme autres modes de réalisation de l'invention, on peut citer l'orthoborate de gadolinium dopé au cérium, l'orthoborate de gadolinium dopé au thulium, tous deux de structure pseudo-vatérite, l'orthoborate de lanthane dopé au thulium de structure aragonite.

L'invention concerne aussi, à titre de précurseur des borates qui viennent d'être décrits, un hydroxycarbonate de bore et de terre rare.

Cet hydroxycarbonate est caractérisé en ce qu'il se présente sous forme de particules cubiques, parallélépipédiques ou sphériques et en ce qu'il présente un indice de dispersion d'au plus 0,8.

Cet hydroxycarbonate peut comprendre en outre à titre d'additif un élément qui est du même type que les dopants qui ont été décrits plus haut.

La terre rare constitutive de l'hydroxycarbonate (autre que l'additif) appartient généralement au groupe des terres rares qui n'ont pas de propriété de luminescence. Ainsi, cette terre rare constitutive du borate peut être choisie dans le groupe comprenant l'yttrium, le gadolinium, le lanthane, le lutécium et le scandium. Elle peut être plus particulièrement l'yttrium et/ou le gadolinium.

Par ailleurs, les caractéristiques de granulométrie, de morphologie, d'homogénéité et d'absence d'agglomération qui ont été mentionnées pour les borates de l'invention se retrouvent dans les précurseurs. Ces derniers peuvent aussi se présenter sous forme de particules entières au sens donné plus haut. Ainsi, tout ce qui a été décrit sur les caractéristiques pour les borates s'applique aussi ici.

Comme autres précurseurs nouveaux, l'invention concerne encore un hydroxycarbonate de bore et d'yttrium et un hydroxycarbonate de bore, de gadolinium et d'yttrium, comprenant tous les deux en outre du terbium, qui présentent des propriétés de luminescence dans le vert. A la connaissance de la Demanderesse, il n'existait pas jusqu'à présent de produit de ce type ayant en outre des propriétés de luminophore. Pour ce précurseur, la quantité de terbium peut être comprise entre 5 et 50%, quantité exprimée comme précédemment.

Enfin, ce dernier précurseur peut aussi présenter un indice de dispersion d'au plus 0,8 et la même morphologie cubique, parallélépipédique ou sphérique que celle décrite plus haut. Il peut, là encore, présenter les mêmes caractéristiques de granulométrie, d'homogénéité et d'absence d'agglomération que celles des autres hydroxycarbonates de l'invention.

De par leurs propriétés, les borates de l'invention et les hydroxycarbonate de bore et d'yttrium et à dopant terbium décrits plus haut ou tels qu'obtenus par les procédés décrits ci-dessus peuvent être utilisés comme luminophores. Ils peuvent être utilisés en particulier en luminescence basse tension, notamment dans la fabrication de tout dispositif mettant en oeuvre cette luminescence basse tension, comme les écrans avec effet de champ. Ces borates et hydroxycarbonates présentent en outre des propriétés de luminescence sous excitation électromagnétique dans le domaine des longueurs d'onde utilisées dans les systèmes à plasma et dans les lampes à vapeur de mercure. Ainsi, ils peuvent être utilisés comme luminophores dans les systèmes à plasma (écran de visualisation ou système d'éclairage) ou dans les lampes trichromatiques.

Enfin, l'invention concerne aussi les dispositifs luminescents, du type écrans avec effet de champ par exemple, incorporant les borates ou hydroxycarbonates décrits plus haut ou tels qu'obtenus par les procédés décrits ci-dessus. Dans ces dispositifs, les luminophores sont disposés sur les écrans soumis à l'excitation de basse énergie. De même, l'invention concerne les systèmes à plasma ou à vapeur de mercure dans la fabrication desquels les borates ou les hydroxycarbonates peuvent rentrer. La mise en oeuvre des luminophores dans la fabrication des dispositifs à luminescence basse tension ou des systèmes à plasma se fait selon des techniques bien connues par exemple par sérigraphie, électrophorèse ou sédimentation.

Des exemples vont maintenant être donnés.

EXEMPLES

Deux types de précurseurs sont utilisés pour ces synthèses : un carbonate de terre rare $Ln_2(CO_3)_3$, $xH_2O$ et hydroxycarbonate de terre rare $LnOHCO_3$ (Ln = terre rare).

Ces précurseurs sont utilisés en suspension dans l'eau, le carbonate et l'hydroxycarbonate ayant été précipités au préalable par réaction du bicarbonate d'ammonium et d'ammoniaque sur des nitrates ou des co-nitrates de terres rares, lavé puis séché à l'étuve (50°C).

Une solution d'acide borique est utilisée comme second réactif.

La quantité de carbonate est telle que la concentration en terres rares est de 0,2 M après l'ajout d'acide.

La quantité d'acide borique est telle qu'on ait le rapport B/Ln adéquat.

Le mode opératoire est le suivant :

La suspension de carbonate ou d'hydroxycarbonate introduite en fond de cuve du réacteur, est chauffée à la température T souhaitée et agitée fortement. On ajoute, à l'aide d'une pompe péristaltique, la solution d'acide borique (30 mn environ de temps d'introduction), et on laisse le mélange réactionnel sous agitation encore pendant deux heures à compter de la fin de l'addition. Le précipité obtenu est filtré, sur fritté, lavé par de l'eau millipore, puis séché en étuve à 110°C. La poudre est finalement lavée avec une quantité suffisante d'acide nitrique dilué afin d'éliminer les traces possibles de carbonate n'ayant pas totalement réagi.

La poudre obtenue est ensuite calcinée dans un four à moufle (sous air) à 1100°C pendant deux heures.

Tous les composés décrits par la suite ont la même structure cristallographique, déterminée par diffraction des RX :

- avant calcination : $LnB(OH)_4CO_3$ (hydroxycarbonate de bore et de terre rare Fiche JCPDS 40-508)
- après calcination : $LnBO_3$ (orthoborate de structure pseudo-vatérite, JCPDS 16-277).

Dans les exemples, la granulométrie a été déterminée selon la technique Cilas précitée. On précise en plus que la mesure a été effectuée sur une dispersion du produit dans une solution aqueuse à 0,05% en poids d'hexamétaphosphate de sodium et qui a préalablement subi un passage à la sonde à ultra-sons (sonde avec embout de 13mm de diamètre, 20KHz, 120W) pendant 3 minutes.

Les exemples 1 à 4 qui suivent concernent la synthèse d'orthoborate d'yttrium $YBO_3$ dopé à l'europium.

EXEMPLE 1

Le précurseur utilisé est un carbonate mixte d'yttrium et d'europium. La composition finale visée est $Y_{0,9}Eu_{0,1}BO_3$.

La température d'attaque est de T = 70°C et le rapport [B] / [Ln] = 1,5.

Caractéristiques:

Avant calcination, le produit se présente sous forme de petits cubes de diamètre moyen CILAS de 2μm avec un indice de dispersion σ/m = 0,6.

Après calcination, la morphologie et la taille sont conservées mais avec un indice de dispersion légèrement plus élevé σ/m = 0,7.

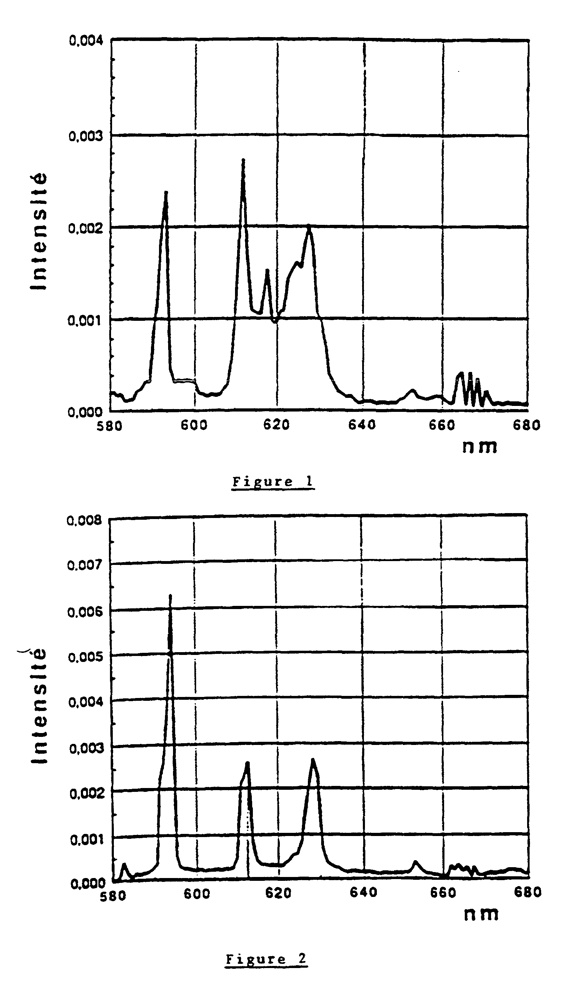

La figure 1 est le graphe donnant l'intensité d'émission en fonction de la longueur d'onde pour ce borate sous une excitation à 254nm.

EXEMPLE 2

On reproduit l'exemple 1, mais avec une température d'attaque de 90°C.

Caractéristiques:

Avant calcination, le produit se présente sous forme de petits cubes de diamètre moyen CILAS de 5μm avec un indice de dispersion σ/m = 0,4.

Après calcination, la morphologie est parfaitement conservée (σ/m = 0,4).

EXEMPLE 3

Le précurseur utilisé est un hydroxycarbonate mixte d'yttrium et d'europium. La composition finale visée est $Y_{0,9}Eu_{0,1}BO_3$.

La température d'attaque est de 70°C et le rapport [B] / [Ln] de 1,05.

Caractéristiques:

Avant calcination, le produit se présente sous forme de petits cubes de diamètre moyen CILAS de 3μm avec un indice de dispersion σ/m = 0,5.

Après calcination. la morphologie et la taille des particules restent inchangées mais l'indice de dispersion est de 0,6.

EXEMPLE 4

On reproduit l'exemple 3, mais avec une température d'attaque de 40°C.

Caractéristiques:

Avant calcination, le produit se présente sous forme de petits cubes de diamètre moyen CILAS de 1 μm avec un indice de dispersion σ/m = 0,6.

Après calcination, la morphologie reste inchangée, mais l'indice de dispersion est de 0,7.

EXEMPLE 5

Cet exemple concerne la synthèse d'un orthoborate mixte d'yttrium et de gadolinium (YGd)BO$_3$ dopé à l'europium.

Le précurseur utilisé est un carbonate mixte d'yttrium, de gadolinium et d'europium. La composition finale est $Y_{0,45}Gd_{0,45}Eu_{0,1}BO_3$.

La température d'attaque est de 70°C et le rapport stoechiométrique utilisé [B] / [Ln] de 1,05.

Caractéristiques:

Avant calcination, le produit se présente sous forme de petits cubes de diamètre moyen CILAS de 1,5μm avec un indice de dispersion σ/m = 0,5.

Après calcination, la morphologie et la taille sont inchangées (σ/m = 0,5).

EXEMPLE 6

Cet exemple concerne la synthèse d'un orthoborate d'yttrium YBO$_3$ dopé au terbium.

Le précurseur utilisé est un carbonate mixte d'yttrium et de terbium. La composition finale visée est $Y_{0,8}Tb_{0,2}BO_3$.

La température d'attaque est de 70°C et le rapport stoechiométrique utitisë [B] / [Ln] de 1,5.

Caractéristiques:

Avant calcination, le produit se présente sous forme de petits cubes de diamètre moyen CILAS de 1,5μm avec un indice de dispersion σ/m = 0,7. Ce produit présente la particularité de luminescer dans le vert directement après séchage à 110°C.

Après calcination, la morphologie reste inchangée (σ/m = 0.7).

EXEMPLE 7

Cet exemple concerne la synthèse d'un orthoborate mixte d'yttrium et de gadolinium (YGd)BO$_3$ dopé au terbium.

Le précurseur utilisé est un carbonate mixte d'yttrium, de gadolinium et de terbium. La composition finale visée est $Y_{0,4}Gd_{0,4}Tb_{0,2}BO_3$.

La température d'attaque est de 70°C et le rapport stoechiométrique utilisé [B] / [Ln] de 1,5.

Caractéristiques:

Avant calcination, le produit se présente sous forme de petits cubes de diamètre moyen CILAS de 1,5μm avec un indice de dispersion σ/m = 0,6. Ce produit présente la particularité de luminescer dans le vert directement après séchage à 110°C.

Après calcination, la morphologie et la taille sont inchangées mais l'indice de dispersion σ/m est égal à 0.7.

EXEMPLE 8

Cet exemple concerne la synthèse d'un orthoborate de gadolinium dopé au cérium et au praséodyme.

Le précurseur utilisé est un carbonate mixte de gadolinium, cérium et praséodyme. La composition finale visée est $Gd_{0,9}Ce_{0,05}Pr_{0,05}BO_3$.

La température d'attaque est de 70°C et le rapport stoechiométrique utilisé [B] / [Ln] de 1,5.

Caractéristiques:

Avant calcination, le produit se présente sous forme de petits cubes de diamètre moyen CILAS de 4μm avec un indice de dispersion σ/m = 0,5.

EXEMPLE 9

Cet exemple concerne la synthèse d'un orthoborate de gadolinium dopé au cérium et au terbium.

Le précurseur utilisé est un carbonate mixte de cérium, gadolinium et de praséodyme.

La composition finale visée est $Ce_{0,3}Gd_{0,5}Tb_{0,2}BO_3$.

La température d'attaque est de 70°C et le rapport stoechiométrique utilisé [B] / [Ln] de 1,5.

Caractéristiques:

Avant calcination, le produit se présente sous forme de petits cubes de diamètre moyen CILAS de 4µm avec un indice de dispersion σ/m = 0,5.

EXEMPLE 10

On reprend l'exemple 1, mais l'on procède à l'attaque sous un balayage d'azote afin d'éliminer plus rapidement le $CO_2$ formé au cours de la réaction. Les particules obtenues sont de plus fine granulométrie qu'en absence de balayage.

Caractéristiques :

Avant calcination, le produit se présente sous forme de petits grains parallélépipédiques de diamètre moyen CILAS de 1µm avec un indice de dispersion σ/m = 0,7.

Après calcination, la morphologie est conservée. Le diamètre moyen CILAS passe à 1,5µm, alors que l'indice de dispersion reste inchangé (σ/m 0,7).

EXEMPLE 11

On prépare le même produit que celui de l'exemple 1 mais le mode de synthèse consiste à attaquer un carbonate mixte d'yttrium et d'europium (fraîchement précipité) directement dans les eaux-mères de précipitation. On y ajoute alors l'acide borique sous forme cristallisée et on chauffe à 70°C tout en agitant (2 heures). Le reste du procédé est identique au mode opératoire général.

Caractéristiques:

Avant et après calcination, le produit se présente sous la forme de petites sphères de diamètre moyen CILAS d'environ un micron et très monodisperses (σ/m = 0,5).

EXEMPLE 12

Cet exemple concerne la synthèse d'un orthoborate de gadolinium $GdBO_3$ dopé au cérium.

Le précurseur utilisé est un carbonate mixte de gadolinium et de cérium. La composition finale est $Gd_{0,95}Ce_{0,05}BO_3$.

La température d'attaque est de 70°C et le rapport stoechiométrique utilisé [B]/[Ln] de 1,5.

Caractéristiques:

Avant calcination à 1100°C sous air, le produit se présente sous forme de petits cubes de diamètre moyen CILAS de 2,2µm avec un indice de dispersion σ/m = 0,6.

Après calcination, la morphologie reste inchangée. Le produit a une structure pseudo-vatérite.

EXEMPLE 13

Cet exemple concerne la synthèse d'un orthoborate de lanthane $LaBO_3$ dopé au thulium.

Le précurseur utilisé est un carbonate mixte de lanthane et de thulium. La composition finale est $La_{0,99}Tm_{0,01} BO_3$.

On procède comme dans l'exemple 12.

Caractéristiques:

Avant calcination, le produit se présente sous forme de plaquettes légèrement agglomérées et de taille moyenne CILAS de 4,8µm avec un indice de dispersion σ/m = 0,75.

Après calcination à 1100°C sous air, la morphologie reste inchangée.

EXEMPLE 14

Cet exemple concerne la synthèse d'un orthoborate de gadolinium $GdBO_3$ dopé au thulium.

Le précurseur utilisé est un carbonate mixte de gadolinium et de thulium. La composition finale est $Gd_{0,99}Tm_{0,01}BO_3$.

La température d'attaque est de 70°C et le rapport stoechiométrique utilisé [B]/[Ln] de 1,5.

Caractéristiques:

Avant calcination le produit présente un diamètre moyen CILAS de 2,1 µm avec un indice de dispersion σ/m = 0,6. Après calcination à 1100°C sous air, la morphologie reste inchangée.

**Revendications**

1. Borate de terre rare de formule $LnBO_3$, Ln représentant au moins une terre rare, **caractérisé en ce qu'**il se présente sous forme de particules cubiques, parallélépipédiques ou sphériques et **en ce qu'**il présente un indice de dispersion d'au plus 0,8.

2. Borate selon la revendication 1, **caractérisé en ce qu'**il se présente sous forme de particules entières.

3. Borate selon la revendication 1 ou 2, **caractérisé en ce qu'**il comprend en outre, à titre de dopant, au moins un élément choisi parmi l'antimoine, le bismuth et les terres rares autres que celle constitutive du borate, la terre rare dopante pouvant être plus particulièrement le cérium, le terbium, l'europium, le thulium, l'erbium et le praséodyme.

**4.** Borate selon l'une des revendications précédentes, **caractérisé en ce que** la terre rare constitutive de celui-ci appartient au groupe comprenant l'yttrium, le gadolinium, le lanthane, le lutécium et le scandium.

**5.** Borate d'au moins un élément choisi parmi l'yttrium, le gadolinium, le scandium et le lutécium selon l'une des revendications précédentes, **caractérisé en ce qu'**il comprend, à titre de dopant, de l'europium et **en ce qu'**il présente un maximum d'intensité d'émission dans la gamme de longueur d'onde comprise entre 600 et 650nm sous excitation à 254nm.

**6.** Borate selon la revendication précédente, **caractérisé en ce que** l'élément précité est l'yttrium et/ou le gadolinium.

**7.** Borate selon l'une des revendications précédentes, **caractérisé en ce qu'**il présente une taille moyenne de particules d'au plus 10μm.

**8.** Borate selon l'une des revendications précédentes, **caractérisé en ce qu'**il présente une teneur en élément dopant d'au plus 50% en mole.

**9.** Hydroxycarbonate de bore et de terre rare de formule $LnB(OH)_4CO_3$, Ln représentant au moins une terre rare, **caractérisé en ce qu'**il se présente sous forme de particules cubiques, parallélépipédiques ou sphériques et **en ce qu'**il présente un indice de dispersion d'au plus 0,8.

**10.** Hydroxycarbonate selon la revendication 9, **caractérisé en ce qu'**il comprend en outre au moins un élément choisi parmi l'antimoine, le bismuth et les terres rares autres que celle constitutive de l'hydroxycarbonate.

**11.** Hydroxycarbonate selon l'une des revendications 9 ou 10, **caractérisé en ce que** la terre rare constitutive de celui-ci appartient au groupe comprenant l'yttrium, le gadolinium, le lanthane, le lutécium et le scandium.

**12.** Hydroxycarbonate de bore et d'yttrium ou hydroxycarbonate de bore, de gadolinium et d'yttrium de formule $LnB(OH)_4CO_3$, Ln représentant la ou les terres rares, comprenant en outre du terbium, à propriétés de luminescence.

**13.** Hydroxycarbonate selon la revendication 12, **caractérisé en ce qu'**il présente un indice de dispersion d'au plus 0,8.

**14.** Hydroxycarbonate selon la revendication 12 ou 13, **caractérisé en ce qu'**il se présente sous forme de particules cubiques, parallélépipédiques ou sphériques.

**15.** Hydroxycarbonate selon l'une des revendications 9 à 14, **caractérisé en ce qu'**il se présente sous forme de particules entières.

**16.** Procédé de préparation d'un hydroxycarbonate de bore et de terre rare de formule $LnB(OH)_4CO_3$, Ln représentant au moins une terre rare, **caractérisé en ce qu'**on fait réagir un carbonate ou un hydroxycarbonate de terre rare avec de l'acide borique, le milieu réactionnel se présentant sous forme d'une solution aqueuse avec un rapport massique eau/acide borique+carbonate d'au moins 300%.

**17.** Procédé de préparation d'un borate de terre rare de formule $LnBO_3$, **caractérisé en ce qu'**on fait réagir un carbonate ou un hydroxycarbonate de terre rare avec de l'acide borique, le milieu réactionnel se présentant sous forme d'une solution aqueuse avec un rapport massique eau/acide borique+carbonate d'au moins 300%, et on calcine le produit de la réaction.

**18.** Procédé selon la revendication 16 ou 17, **caractérisé en ce que** l'on forme le milieu réactionnel en utilisant de l'eau dans un rapport massique eau/acide borique+carbonate d'au moins 1000%.

**19.** Procédé selon l'une des revendications 16 à 18, **caractérisé en ce qu'**on conduit la réaction en éliminant le $CO_2$ formé.

**20.** Procédé selon l'une des revendications 17 à 19, **caractérisé en ce qu'**on calcine à une température comprise entre 500 et 1100°C de préférence sous air.

**21.** Procédé selon l'une des revendications 16 à 20, **caractérisé en ce qu'**on fait réagir l'acide borique avec le carbonate ou l'hydroxycarbonate de terre rare dans les eaux-mères de celui-ci.

**22.** Utilisation comme luminophore d'un borate selon l'une des revendications 1 à 8 ou d'un borate obtenu par le procédé selon l'une des revendications 17 à 21 ou d'un hydroxycarbonate selon l'une des revendications 9 à 15.

**23.** Utilisation comme luminophore en luminescence basse tension, dans des systèmes à plasma ou dans les lampes trichromatiques d'un borate selon l'une des revendications 1 à 8 ou d'un borate obtenu par le procédé selon l'une des revendications 17 à 21 ou d'un hydroxycarbonate selon l'une des revendications 9 à 15.

**24.** Dispositif mettant en oeuvre une luminescence basse tension, **caractérisé en ce qu'**il comprend un borate selon l'une des revendications 1 à 8 ou d'un borate obtenu par le procédé selon l'une des revendications 17 à 21 ou d'un hydroxycarbonate selon l'une des revendications 9 à 15.

**25.** Système à plasma, **caractérisé en ce qu'**il comprend un borate selon l'une des revendications 1 à 8 ou d'un borate obtenu par le procédé selon l'une des revendications 17 à 21 ou d'un hydroxycarbonate selon l'une des revendications 9 à 15.

**26.** Lampe trichromatique, **caractérisée en ce qu'**elle comprend un borate selon l'une des revendications 1 à 8 ou d'un borate obtenu par le procédé selon l'une des revendications 17 à 21 ou d'un hydroxycarbonate selon l'une des revendications 9 à 15.

**Claims**

**1.** Rare-earth borate of formula $LnBO_3$, Ln representing at least one rare earth, **characterized in that** it is in the form of cubic, parallelepipedal or spherical particles and **in that** it has a dispersion index of not more than 0.8.

**2.** Borate according to Claim 1, **characterized in that** it is in the form of whole particles.

**3.** Borate according to Claim 1 or 2, **characterized in that** it moreover comprises, as dopant, at least one element chosen from antimony, bismuth and rare earths other than that making up the borate, it being possible for the dopant rare earth more particularly to be cerium, terbium, europium, thulium, erbium and praseodymium.

**4.** Borate according to one of the preceding claims, **characterized in that** the rare earth making up this borate belongs to the group consisting of yttrium, gadolinium, lanthanum, lutetium and scandium.

**5.** Borate of at least one element chosen from yttrium, gadolinium, scandium and lutetium according to one of the preceding claims, **characterized in that** it comprises europium as dopant and **in that** it has an emission intensity maximum in the wavelength range between 600 and 650 nm under excitation at 254 nm.

**6.** Borate according to the preceding claim, **characterized in that** the abovementioned element is yttrium and/or gadolinium.

**7.** Borate according to one of the preceding claims, **characterized in that** it has an average particle size of not more than 10 $\mu$m.

**8.** Borate according to one of the preceding claims, **characterized in that** it has a content of dopant element of not more than 50 mol%.

**9.** Rare-earth boron hydroxycarbonate of formula $LnB(OH)_4CO_3$, Ln representing at least one rare earth, **characterized in that** it is in the form of cubic, parallelepipedal or spherical particles and **in that** it has a dispersion index of not more than 0.8.

**10.** Hydroxycarbonate according to Claim 9, **characterized in that** it moreover comprises at least one element chosen from antimony, bismuth and rare earths other than that making up the hydroxycarbonate.

**11.** Hydroxycarbonate according to either of Claims 9 and 10, **characterized in that** the rare earth making up this hydroxycarbonate belongs to the group consisting of yttrium, gadolinium, lanthanum, lutetium and scandium.

**12.** Yttrium boron hydroxycarbonate or yttrium gadolinium boron hydroxycarbonate of formula $LnB(OH)_4CO_3$, Ln representing rare earth(s), also comprising terbium, having luminescent properties.

**13.** Hydroxycarbonate according to Claim 12, **characterized in that** it has a dispersion index of not more than 0.8.

**14.** Hydroxycarbonate according to Claim 12 or 13, **characterized in that** it is in the form of cubic, parallelepipedal or spherical particles.

**15.** Hydroxycarbonate according to one of Claims 9 to 14, **characterized in that** it is in the form of whole particles.

**16.** Process for the preparation of a rare-earth boron hydroxycarbonate of formula $LnB(OH)_4CO_3$, Ln representing at least one rare earth, **characterized in that** a rare-earth carbonate or hydroxycarbonate is reacted with boric acid, the reaction medium being in the form of an aqueous solution in a water/boric acid + carbonate mass ratio of at least 300%.

**17.** Process for the preparation of a rare-earth borate of formula $LnBO_3$, **characterized in that** a rare-earth carbonate or hydroxycarbonate is reacted with boric acid, the reaction medium being in the form of an aqueous solution in a water/boric acid + carbonate mass ratio of at least 300%, and the reaction product is calcined.

**18.** Process according to Claim 16 or 17,

**characterized in that** the reaction medium is formed using water in a water/boric acid + carbonate mass ratio of at least 1000 %.

19. Process according to one of Claims 16 to 18, **characterized in that** the reaction is carried out while removing the $CO_2$ formed.

20. Process according to one of Claims 17 to 19, **characterized in that** calcination is carried out at a temperature of between 500 and 1100°C, preferably under air.

21. Process according to one of Claims 16 to 20, **characterized in that** boric acid is reacted with the rare-earth carbonate or hydroxycarbonate in the mother liquors thereof.

22. Use, as a luminophore, of a borate according to one of Claims 1 to 8 or of a borate obtained by the process according to one of Claims 17 to 21 or of a hydroxycarbonate according to one of Claims 9 to 15.

23. Use, as a luminophore in low-voltage luminescence in plasma systems or in trichromatic lamps, of a borate according to one of Claims 1 to 8 or of a borate obtained by the process according to one of Claims 17 to 21 or of a hydroxycarbonate according to one of Claims 9 to 15.

24. Device using low-voltage luminescence, **characterized in that** it comprises a borate according to one of Claims 1 to 8 or a borate obtained by the process according to one of Claims 17 to 21 or a hydroxycarbonate according to one of Claims 9 to 15.

25. Plasma system, **characterized in that** it comprises a borate according to one of Claims 1 to 8 or a borate obtained by the process according to one of Claims 17 to 21 or a hydroxycarbonate according to one of Claims 9 to 15.

26. Trichromatic lamp, **characterized in that** it comprises a borate according to one of Claims 1 to 8 or a borate obtained by the process according to one of Claims 17 to 21 or a hydroxycarbonate according to one of Claims 9 to 15.

**Patentansprüche**

1. Borat seltener Erde der Formel $LnBO_3$, wobei Ln wenigstens eine seltene Erde darstellt, **dadurch gekennzeichnet, dass** es in Form würfelförmiger, parallelepipedförmiger oder kugelförmiger Partikel vorliegt und dadurch, dass es einen Dispersionsindex von höchstens 0,8 aufweist.

2. Borat gemäß Anspruch 1, **dadurch gekennzeichnet, dass** es in Form ganzer Partikel vorliegt.

3. Borat gemäß Anspruch 1 oder 2, **dadurch gekennzeichnet, dass** es des weiteren als Dotierstoff wenigstens ein Element gewählt aus Antimon, Bismut und seltenen Erden, andere als jene, die Bestandteil des Borats sind, umfasst, wobei die dotierenden seltenen Erden insbesondere Cer, Terbium, Europium, Thulium, Erbium, und Praseodym sein können.

4. Borat gemäß einem der vorausgegangenen Ansprüche, **dadurch gekennzeichnet, dass** die seltene Erde, die seinen Bestandteil bildet, zu der Gruppe gehört, welche Yttrium, Gadolinium, Lanthan, Lutetium und Scandium umfasst.

5. Borat wenigstens eines Elements gewählt aus Yttrium, Gadolinium, Scandium und Lutetium gemäß einem der vorausgegangenen Ansprüche, **dadurch gekennzeichnet, dass** es als Dotierstoff Europium umfasst, und dadurch, dass es eine maximale Emissionsintensität im Bereich der Wellenlänge aufweist, die zwischen 600 und 650nm durch Anregung mit 254nm liegt.

6. Borat gemäß dem vorausgegangenen Anspruch, **dadurch gekennzeichnet, dass** das vorgenannte Element Yttrium und/oder Gadolinium ist.

7. Borat gemäß einem der vorausgegangenen Ansprüche, **dadurch gekennzeichnet, dass** es eine durchschnittliche Partikelgröße von höchstens 10µm aufweist.

8. Borat gemäß einem der vorausgegangenen Ansprüche, **dadurch gekennzeichnet, dass** es einen Gehalt des dotierenden Elements von höchstens 50% in mol aufweist.

9. Hydroxycarbonat von Bor und von seltener Erde der Formel $LnB(OH)_4CO_3$, wobei Ln wenigstens eine seltene Erde darstellt, **dadurch gekennzeichnet, dass** es in Form würfelförmiger, parallelepipedförmiger oder kugelförmiger Partikel vorliegt und dadurch, dass es einen Dispersionsindex von höchstens 0,8 aufweist.

10. Hydroxycarbonat gemäß Anspruch 9, **dadurch gekennzeichnet, dass** es des weiteren wenigstens ein Element gewählt aus Antimon, Bismut und seltenen Erden, andere als jene, die Bestandteil des Hydroxycarbonats sind, umfasst.

11. Hydroxycarbonat gemäß einem der Ansprüche 9 oder 10, **dadurch gekennzeichnet, dass** die seltene Erde, die seinen Bestandteil bildet, zu der Gruppe gehört, welche Yttrium, Gadolinium, Lanthan, Lutetium und Scandium umfasst.

12. Hydroxycarbonat von Bor und Yttrium oder Hydroxycarbonat von Bor, Gadolinium und Yttrium der Formel $LnB(OH)_4CO_3$, wobei Ln die seltene(n) Erde(n) darstellt und des weiteren Terbium mit Lumineszenzeigenschaften umfasst.

13. Hydroxycarbonat gemäß Anspruch 12, **dadurch gekennzeichnet, dass** es einen Dispersionsindex von höchstens 0,8 aufweist.

14. Hydroxycarbonat gemäß Anspruch 12 oder 13, **dadurch gekennzeichnet, dass** es in Form würfelförmiger, parallelepipedförmiger oder kugelförmiger Partikel vorliegt.

15. Hydroxycarbonat gemäß einem der Ansprüche 9 bis 14, **dadurch gekennzeichnet, dass** es in Form ganzer Partikel vorliegt.

16. Verfahren zur Herstellung eines Hydroxycarbonats von Bor und von seltenen Erden der Formel $LnB(OH)_4CO_3$, wobei Ln wenigstens eine seltene Erde darstellt, **dadurch gekennzeichnet, dass** ein Carbonat oder ein Hydroxycarbonat der seltenen Erde mit Borsäure zur Reaktion gebracht wird, wobei das Reaktionsmedium in Form einer wässrigen Lösung mit einem Massenverhältnis Wasser/Borsäure + Carbonat von wenigstens 300% vorliegt.

17. Verfahren zur Herstellung eines Borats seltener Erde der Formel $LnBO_3$, **dadurch gekennzeichnet, dass** ein Carbonat oder ein Hydroxycarbonat der seltenen Erde mit Borsäure zur Reaktion gebracht wird, wobei das Reaktionsmedium in Form einer wässrigen Lösung mit einem Massenverhältnis Wasser/Borsäure + Carbonat von wenigstens 300% vorliegt, und das Reaktionsprodukt kalziniert wird.

18. Verfahren gemäß Anspruch 16 oder 17, **dadurch gekennzeichnet, dass** das Reaktionsmedium unter Verwendung von Wasser in einem Massenverhältnis Wasser/Borsäure + Carbonat von wenigstens 1000% gebildet wird.

19. Verfahren gemäß einem der Ansprüche 16 bis 18, **dadurch gekennzeichnet, dass** die Reaktion durchgeführt wird, wobei das gebildete $CO_2$ eliminiert wird.

20. Verfahren gemäß einem der Ansprüche 17 bis 19, **dadurch gekennzeichnet, dass** bei einer Temperatur kalziniert wird, die zwischen 500 und 1000°C liegt, vorzugsweise unter Luft.

21. Verfahren gemäß einem der Ansprüche 16 bis 20, **dadurch gekennzeichnet, dass** die Borsäure mit dem Carbonat oder Hydroxycarbonat der seltenen Erde in der Mutterlauge desselben zur Reaktion gebracht wird.

22. Verwendung als Leuchtstoff eines Borats gemäß einem der Ansprüche 1 bis 8 oder eines Borats, welches durch das Verfahren gemäß einem der Ansprüche 17 bis 21 erhalten wird, oder eines Hydroxycarbonats gemäß einem der Ansprüche 9 bis 15.

23. Verwendung als Leuchtstoff mit Niederspannungslumineszenz in Plasmasystemen oder in trichromatischen Lampen eines Borats gemäß einem der Ansprüche 1 bis 8 oder eines Borats, welches durch das Verfahren gemäß einem der Ansprüche 17 bis 21 erhalten wird, oder eines Hydroxycarbonats gemäß einem der Ansprüche 9 bis 15.

24. Vorrichtung, welche eine Niederspannungslumineszenz verwendet, **dadurch gekennzeichnet, dass** sie ein Borat gemäß einem der Ansprüche 1 bis 8 oder ein Borat, welches durch das Verfahren gemäß einem der Ansprüche 17 bis 21 erhalten wird, oder ein Hydroxycarbonat gemäß einem der Ansprüche 9 bis 15 umfasst.

25. Plasmasystem, **dadurch gekennzeichnet, dass** es ein Borat gemäß einem der Ansprüche 1 bis 8 oder ein Borat, welches durch das Verfahren gemäß einem der Ansprüche 17 bis 21 erhalten wird, oder ein Hydroxycarbonats gemäß einem der Ansprüche 9 bis 15 umfasst.

26. Trichromatische Lampe, **dadurch gekennzeichnet, dass** sie ein Borat gemäß einem der Ansprüche 1 bis 8 oder ein Borat, welches durch das Verfahren gemäß einem der Ansprüche 17 bis 21 erhalten wird, oder ein Hydroxycarbonat gemäß einem der Ansprüche 9 bis 15 umfasst.

Figure 1

Figure 2